Europäisches Patentamt

European Patent Office

Office européen des brevets

(19)

(11) Numéro de publication: **0 209 441**
**B1**

(12) **FASCICULE DE BREVET EUROPEEN**

(45) Date de publication du fascicule du brevet:
**31.01.90**

(51) Int. Cl.⁴: **H04M 11/08, H03M 7/00**

(21) Numéro de dépôt: **86401469.1**

(22) Date de dépôt: **02.07.86**

(54) **Procédé de transcodage d'une image vidéotex pour la rendre compatible avec plusieurs systèmes vidéotex.**

(30) Priorité: **08.07.85 FR 8510417**

(43) Date de publication de la demande:
**21.01.87 Bulletin 87/4**

(45) Mention de la délivrance du brevet:
**31.01.90 Bulletin 90/5**

(84) Etats contractants désignés:
**BE DE GB IT NL SE**

(56) Documents cités:
**IBM TECHNICAL DISCLOSURE BULLETIN,
vol. 26, no. 10B, mars 1984, pages 5588-5592, New York,
US; C. CODRAI et al.: "Multiple line videotex adapter"**

(73) Titulaire: **Nahon, Georges, 14, Allée des Orchidées,
F-92220 Bagneux(FR)**

(72) Inventeur: **Nahon, Georges, 14, Allée des Orchidées,
F-92220 Bagneux(FR)**

(74) Mandataire: **Mongrédien, André et al, c/o
BREVATOME 25, rue de Ponthieu, F-75008 Paris(FR)**

## Description

La présente invention a pour objet un procédé de transcodage d'une image d'un système de vidéotex pour la rendre compatible avec plusieurs systèmes de vidéotex. Plus précisément, l'invention concerne un procédé de transcodage d'un message vidéographique primaire décrivant une image primaire dans un premier langage vidéographique en un message vidéographique secondaire décrivant une image secondaire dans ledit premier langage vidéographique et une image secondaire dans au moins un autre langage vidéographique. Le but de l'invention est l'obtention d'un message vidéographique secondaire produisant des images secondaires essentiellement identiques à l'image primaire, c'est-à-dire des images secondaires qui contiennent l'essentiel des caractéristiques de l'image primaire, notamment dans la forme, la taille et la couleur des objets de cette image, et qui n'en diffèrent éventuellement que dans la représentation d'éléments de détail.

On rappelle que l'expression vidéographie désigne un procédé de télécommunication permettant de présenter à un usager des messages alphanumériques ou graphiques sur un écran de visualisation. Dans une variante de ce procédé, appelée vidéographie diffusée ou télétex, les messages sont systématiquement diffusés par un réseau de télévision et l'usager peut effectuer un choix parmi ces messages. Dans une autre variante de ce procédé, appelée vidéographie interactive ou vidéotex, un réseau de télécommunication assure la transmission des demandes de l'usager et des messages obtenus en réponse. Le système français TELETEL (marque déposée), le système anglais PRESTEL (marque déposée) et le système allemand BILDSCHIRMTEXT (marque déposée) relè vent de cette deuxième variante.

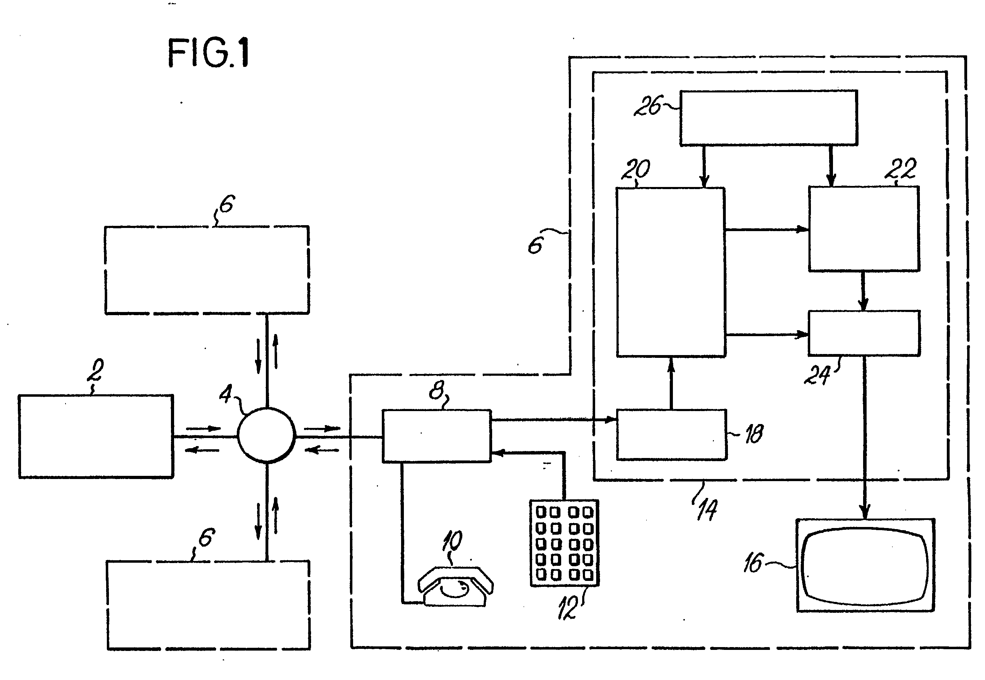

On a représenté schématiquement sur la figure 1 l'architecture d'un système de vidéotex. Ce système est un réseau comprenant un serveur 2, un réseau de transmission 4, qui peut être le réseau téléphonique, et un ensemble de terminaux de vidéotex 6.

Chaque terminal de vidéotex 6 comporte en entrée un modem 8 auquel sont reliés un téléphone 10 pour entrer en communication avec le serveur, un clavier 12 permettant à l'usager de composer et d'envoyer des demandes au serveur, et un circuit 14 relié à un écran de télévision 16. LE circuit se compose d'un décodeur 18 recevant, à travers le modem 8, les messages vidéographiques transmis par le serveur, une mémoire de page 20, un générateur de caractère 22 et un générateur de visualisation 24 délivrant un signal vidéo à l'écran de télévision 16. Une base de temps 26 assure le séquencement des signaux entre les différents moyens du circuit 14.

Chaque système de vidéotex est défini par un langage vidéographique, c'est-à-dire un ensemble de codes de caractère et de codes de commande, et par un protocole de transmission pour transmettre ces codes du serveur vers le terminal de vidéotex. En Europe, les caractéristiques des systèmes de vidéotex sont définies par la norme TCD 6-1 de la CEPT (Commission Européenne des Postes et Télécommunications). Les systèmes de vidéotex tels que PRESTEL, TELETEL et BILDSCHIRMTEXT sont des sous-normes définissant trois niveaux différents de cette norme standard.

Chaque langage vidéographique comporte une liste de caractères alphanumériques, une liste de caractères semi-graphiques, une liste de commandes et une liste d'attributs de visualisation. Ces éléments du langage sont représentés dans le système de vidéotex par des codes, c'est-à-dire une valeur numérique particulière. Celle-ci est en général un octet de données binaires. Il est important de ne pas confondre la valeur numérique qui est un nombre binaire indépendant du langage vidéographe et le code qui associe un élément du langage vidéographique à une valeur numérique, et qui n'a donc un sens que pour un langage vidéographique donné.

Les différents langages vidéographiques ne sont pas compatibles entre eux, d'une part, car à une valeur numérique donnée peuvent correspondre des codes différents dans des langages vidéographiques différents, et d'autre part, car les attributs de visualisation ne sont pas traités de la même manière dans tous les systèmes de vidéotex, voir par exemple IBM TECHNICAL DISCLOSURE BULLETIN, vol. 26, no. 10B, mars 1984, pages 5588–5592, New York, US; C. CODRAI et al.: "Multiple line videotex adapter". Ainsi, par exemple, les attributs de visualisation sont en série dans le système PRESTEL -ils occupent un emplacement de caractère dans la mémoire d'écran- alors qu'ils sont en parallèle dans le système TELETEL- ils occupent un emplacement de mémoire dans un plan de mémoire disposé en parallèle avec le plan de mémoire d'écran. Enfin, dans le système BILDSCHIRMTEXT, les attributs de visualisation peuvent être en série ou en parallèle.

Ces différences rendent impossible la restitution, sur un terminal d'un premier système de vidéotex, d'une image produite par un second système de vidéotex. Le but de l'invention est de supprimer cette limitation. Ceci est réalisé par un procédé de transcodage qui convertit un message vidéographique, correspondant au codage d'une image suivant un premier système de vidéotex, en un autre message vidéographique qui, interprété par des terminaux de différents systèmes de vidéotex, produit sur chacun de ces terminaux une image essentiellement identique à l'image correspondant au message vidéographique de départ.

Ce procédé de transcodage consiste à analyser chaque donnée du message vidéographique de départ et à produire, suivant la nature de cette donnée et le sens du code associé à cette donnée dans le langage vidéographique de départ, une autre donnée ou une suite de données interprétables par plusieurs systèmes de vidéotex et dont le code ou la suite de codes associés a un sens analogue à celui du code associé à la donnée du message vidéographique de départ.

De manière plus précise, l'invention a pour objet un procédé de transcodage d'un message vidéographique primaire décrivant une image primaire dans un premier langage vidéographique en un message vidéographique secondaire décrivant une image secondaire dans ledit premier langage vidéographique et une image secondaire dans au moins un autre langage vidéographique, lesdites images secondaires étant essentiellement identiques à l'image primaire, lesdits messages vidéographiques étant composés d'une suite de données binaires, chaque donnée binaire étant associée, par chaque langage vidéographique un code particulier, ledit procédé de transcodage étant caractérisé en ce que le transcodage de chaque donnée du message vidéographique primaire comprend les opérations suivantes :
- on compare le code du premier langage vidéographique associé à ladite donnée aux codes des autres langages vidéographiques associés à ladite donnée pour déterminer si ledit code est identique auxdits codes ou si ledit code est différent d'au moins un desdits codes,

A) si ledit code est identique auxdits codes, on inscrit la donnée dans le message vidéographique secondaire,
B) si ledit code est différent d'au moins un desdits codes, on détermine si la donnée est associée à un code de caractère ou à un code de commande ou de visualisation,
Ba) si la donnée est associée à un code de caractère, on inscrit une première donnée prédéterminée dans le message vidéographique secondaire,
Bb) si la donnée est associée à un code de commande ou de visualisation, on détermine si ledit code est transcodable,
Bbα) si ledit code n'est pas transcodable, on inscrit une deuxième donnée prédéterminée dans le message vidéographique secondaire,
Bbβ) si ledit code est transcodable, on inscrit dans le message vidéographique secondaire une suite de données telle que les séquences de codes associés à cette suite aient un sens essentiellement identique pour chaque langage vidéographique.

Un code du message vidéographique primaire est transcodable si la fonction qu'il représente existe dans le langage vidéographique secondaire. Dans ce dernier langage, cette fonction peut être représentée par un code unique ou peut n'être représentable que par une suite de codes. Pour faciliter le transcodage du message vidéographique primaire, l'ensemble des codes transcodables peut être contenu dans une table. La consultation de cette table permet de savoir rapidement si un code est transcodable.
Les caractéristiques et avantages de l'invention ressortiront mieux de la description qui va suivre, donnée à titre illustratif mais non limitatif, en référence aux dessins annexés, sur lesquels :

- la figure 1, déjà décrite, représente schématiquement un système de vidéotex,
- la figure 2 illustre l'interconnexion de deux systèmes de vidéotex par l'intermédiaire d'un appareil mettant en oeuvre le procédé de transcodage de l'invention,
- la figure 3 représente la structure de la mémoire d'image d'un terminal du système de vidéotex TELETEL,
- la figure 4 représente la structure de la mémoire d'image d'un terminal du système de vidéotex PRESTEL.

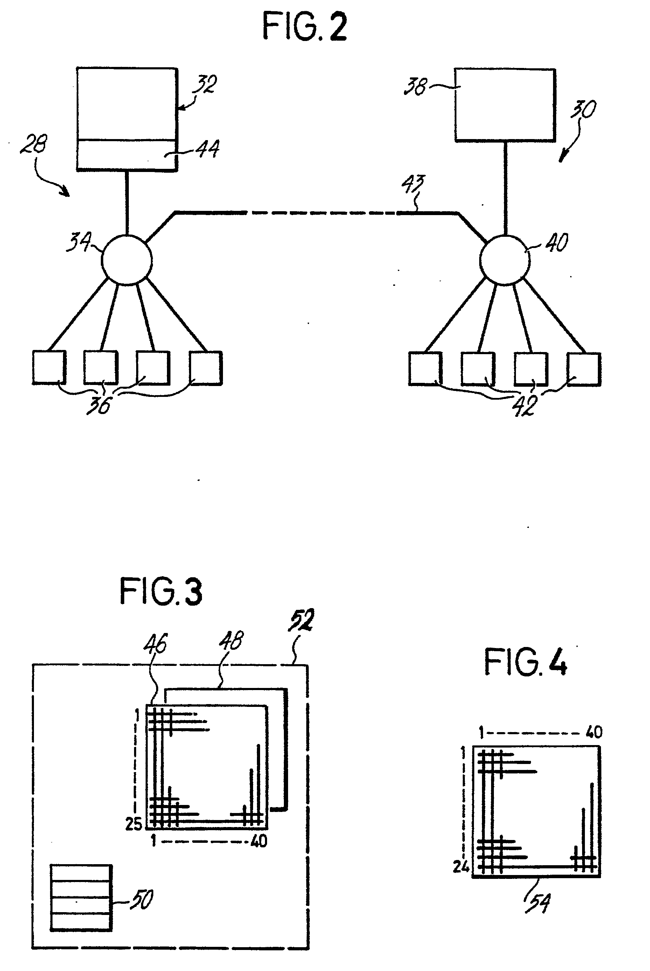

Sur la figure 2, on a représenté un premier système de vidéotex 28 et un deuxième système de vidéotex 30. Chaque système comporte un centre serveur 32, 38, un réseau de transmission 34, 40 et des terminaux 36, 42.
Chaque terminal peut émettre des demandes et recevoir des messages de son centre serveur. Dans le cas classique où les réseaux de transmission sont des réseaux téléphoniques, ces réseaux sont interconnectés. Ceci est symbolisé sur la figure par une liaison 43. Cette liaison qui peut exister dans les systèmes de vidéotex selon l'art antérieur, ne suffit cependant pas à permettre à un terminal d'un système de vidéotex de communiquer avec le centre serveur de l'autre système de vidéotex.
Cette communication est rendue possible selon l'invention par l'adjonction entre ce centre serveur et son réseau de transmission d'un moyen 44 qui réalise un transcodage des messages vidéographiques délivré par ce centre serveur et qui produit ainsi des messages vidéographiques interrétables par les terminaux de chacun des deux systèmes de télétex. A titre d'exemple le moyen 44 a été représenté sur le premier système de vidéotex 28, ce qui permet aux terminaux 36 du second système de télétex 30 de communiquer avec le centre serveur 32 du premier système de télétex 28. Bien entendu, le centre serveur 38 pourrait également être équipé d'un moyen analogue au moyen 44. Les terminaux 36 du premier système de vidéotex 28 pourraient alors communiquer avec le centre serveur 38 du deuxième système de vidéotex 30.
On va maintenant décrire un mode de réalisation du procédé de l'invention en considérant, à titre d'exemple, le cas où le premier système de vidéotex est le système TELETEL et où le second système de vidéotex est le système PRESTEL. Le langage vidéographique du système TELETEL est décrit notamment dans le fascicule "Minitel M1, Spécifications techniques d'utilisation", Sept. 1984 édité par le Ministère français des Postes et Télécommunications et dans la revue RadiodiffusionTélévision, n°182,

"Didon-Antiope, Spécifications techniques", de Télédiffusion De France ; le langage vidéographique du système PRESTEL est décrit en particulier dans "PRESTEL terminal specification". 1980 édité par le ministère britannique des Postes.

Le procédé de l'invention assure le transcodage d'un message vidéographique primaire décrivant une image primaire dans le langage vidéographique du système TELETEL en un message vidéographique secondaire décrivant une image secondaire dans ce langage vidéogrphique et une image secondaire dans le langage vidéographique du système PRESTEL.

Pour une meilleure compréhension du procédé de l'invention, on rappellera tout d'abord qu'un message vidéographique est une suite de données ayant chacune, par exemple, une longueur de un octet. Cette donnée est une valeur associée au profil binaire de l'octet et est représentée par un ensemble de deux nombres hexadécimaux, tels que 5/15. Le terme de code désigne le couple constitué d'un élément d'un langage vidéographique et d'une donnée représentant cet élément. Enfin, un langage vidéographique est défini par un ensemble de codes de caractères, de codes de commande et de codes, ou attributs, de visualisation.

L'incompatibilité entre deux systèmes de vidéotex résulte du fait qu'une même donnée peut correspondre à des codes différents dans les langages vidéographiques de ces systèmes de vidéotex. L'invention se propose de remplacer chacune de ces données par une autre donnée ou par une suite de données qui soit compatible avec les deux systèmes de vidéotex, c'est-à-dire qui soit interprétable par ces deux systèmes et qui produise sur les écrans des terminaux de ces systèmes des images essentiellement identiques.

Avant de décrire le procédé de transcodage de l'invention, il n'est pas inutile de rappeler les caractéristiques des systèmes de vidéotex TELETEL et PRESTEL. On a représenté respectivement sur les tableaux I à V et sur les tableaux VI à VIII les codes constituant les langages vidéographiques des systèmes TELETEL et PRESTEL. Dans chacun de ces tableaux, le numéro de la colonne et le numéro de la ligne à l'intersection desquels se trouve un code constituent respectivement la partie haute et la partie basse de la donnée représentant ce code. Les colonnes sont numérotées de 0 à 7 au moyen des bits $b_7$, $b_6$ et $b_5$, les lignes de 0 à 15 au moyen des bits $b_4$, $b_3$, $b_2$ et $b_1$. Le bit $b_8$ de poids le plus fort d'une donnée est un bit de parité. Les cases du tableau ne correspondant à aucun code sont représentées en grisé.

Le langage vidéographique du système TELETEL est défini par un ensemble de cinq jeux de codes :
- jeu G0 des codes de caractères alphanumériques (tableau I),
- jeu G1 des codes de caractères semi-graphiques, ou mosaïques (tableau II),
- jeu auxiliaire G2 de codes de caractères alphanumériques (tableau III),
- jeu C0 des codes de commande (tableau IV), et
- jeu C1 des codes, ou attributs, de visualisation (tableau V).

De même, le langage vidéographique du système PRESTEL est défini par un ensemble de quatre jeux de codes :
- jeu G0 des codes de caractères alphanumériques (tableau VI),
- jeu G1 des codes de caractères semi-graphiques, ou mosaïques, (tableau II),
- jeu C0 des codes de commande (tableau VII), et
- jeu C1 des codes, ou attributs, de visualisation (tableau VIII).

La comparaison de ces tableaux permet de mettre en évidence les différences suivantes entre le langage vidéographique du système TELETEL et le langage vidéographique du système PRESTEL :
- pour le jeu principal G0, les données 2/3, 2/4 et 5/14 ne correspondent à aucun code du système TELETEL mais ont un sens dans le système PRESTEL ; et les données 5/11, 5/13, 5/14, 5/15, 7/11, 7/13 et 7/15 correspondent à des codes différents dans le système PRESTEL et dans le système TELETEL,
- les jeux G1 de caractère semi-graphiques des systèmes TELETEL et PRESTEL sont identiques,
- le jeu auxiliaire G2 de codes de caractères n'existe que dans le système TELETEL,
- pour le jeu C0 des codes de commande, les données 0/2, 0/3, 0/14, 0/15, 1/2, 1/8, 1/9, 1/13 et 1/15 correspondent à un code uniquement dans le système TELETEL et les codes 0/5, 1/5 et 1/4 ne correspondent qu'à des codes du système PRESTEL.

Pour les attributs de visualisation, les seules données correspondant des codes identiques dans les systèmes PRESTEL et TELETEL sont 4/0 à 4/9, 4/12 et 4/13.

Les systèmes de vidéotex TELETEL et PRESTEL diffèrent également dans la manière de mémoriser une image. On a représenté sur la figure 3 la mémoire d'image d'un terminal TELETEL. ELle comprend une première zone de mémoire 46, ou mémoire d'écran pour mémoriser 25 lignes de 40 caractères qui constituent l'image visualisée, une seconde zone 48 de même taille que la zone de mémoire 46 et mémorisant l'état des attributs parallèles de visualisation, et une zone de mémoire 50 organisée en pile composée de quatre octets pour mémoriser les attributs série. Ces attributs série sont ceux définissant la couleur de fond, le lignage, le masquage et le fond transparent.

La figure 4 représente la structure d'une mémoire d'image d'un terminal PRESTEL. Cette mémoire 52 se compose de 24 lignes de 40 emplacements de caractères. Ces emplacements de caractères contiennent soit un code de caractère, soit un attribut de visualisation.

Les différences entre le langage vidéographique du système TELETEL et 1e langage vidéographique du système PRESTEL, et entre les structures des mémoires d'image des terminaux TELETEL et des terminaux PRESTEL se traduisent par une incompatibilité entre ces deux systèmes de vidéotex. Cette incompatibilité est levée grâce au procédé de transcodage de l'invention qui permet, par exemple, de traduire un message vidéographique primaire décrivant une image primaire dans le langage vidéographique du système vidéotex TELETEL en un message vidéographique secondaire décrivant une image secondaire dans le langage vidéographique du système de vidéotex TELETEL et une image secondaire dans le langage vidéographique du système de vidéotex PRESTEL, ces images secondaires étant essentiellement identiques à l'image primaire.

Le procédé de transcodage de l'invention consiste à analyser chaque donnée du message vidéographique primaire et à produire un message vidéographique secondaire dans lequel chaque donnée du message vidéographique primaire est conservée ou remplacée par une autre donnée ou par une suite de données.

Dans le cas où la donnée du message vidéographique primaire correspond à un même code dans les langages vidéographiques des systèmes TELETEL et PRESTEL, cette donnée est recopiée dans le message vidéographique secondaire. C'est le cas lorsque la donnée du message vidéographique primaire représente un code de caractère du jeu principal G0, à l'exception d'un nombre très limité de codes (voir tableaux I et VI), lorsque la donnée représente un code de caractères du jeu semi-graphique G1 (tableau II) ou lorsque la donnée représente un code de commande de mouvement du curseur (données 0/8 à 0/13, 1/1, 1/4), le code d'échappement (1/11) ou le code de remise à zéro 1/14), ou lorsque la donnée représente l'un des codes de visualisation (tableaux V et VIII) : 4/0 à 4/9, 4/12, 4/13, 5/8 et 5/13.

Dans le cas où la donnée du message vidéographique primaire correspond à un code du langage vidéographique du système TELETEL et à un code différent du langage vidéographique du système PRESTEL, le transcodage de cette donnée dépend de la nature du code associé à cette donnée.

Si ces codes sont des codes de caractères, la donnée du message vidéographique primaire est remplacée par une autre donnée qui est choisie parmi l'ensemble des données représentant un même code de caractère dans les langages vidéographiques des systèmes TELETEL et PRESTEL. Cette donnée de remplacement peut être par exemple le code espace 2/0.

Si la donnée du message vidéographique primaire représente un code de commande ou de visualisation, la première opération du procédé de transcodage consiste à déterminer si la fonction représentée par le code du langage vidéographique du système TELETEL associé à la donnée peut être exprimée au moyen d'un code ou d'une suite de codes du langage vidéographique du système PRESTEL. Si cela n'est pas possible, la donnée est supprimée ou est remplacée par une autre donnée ayant un sens identique pour les deux langages vidéographiques. Cette autre donnée peut être par exemple le code de commande "nul" (0/0) ou une donnée représentant un code inactif pour chacun des deux langages vidéographiques.

Si la fonction représentée par le code de commande du langage vidéographique du système TELETEL associé à la donnée peut être exprimée dans le langage vidéographique du système PRESTEL, le procédé de transcodage de l'invention consiste à inscrire dans le message vidéographique secondaire une suite de données telle que la séquence de codes du langage vidéographique du système TELETEL et la séquence de codes du langage vidéographique du système PRESTEL associées à cette suite de données aient un sens essentiellement identiques à celui du code associé à la donnée du message vidéographique primaire.

Les codes du langage vidéographique du système TELETEL qui n'ont pas d'équivalent ou qu'il n'est pas possible de traduire dans le langage vidéographique du système PRESTEL sont les suivants :
- code de commande : SS2 (code d'appel au jeu auxiliaire G2 de code de caractères), puisque le système PRESTEL ne comprend qu'un jeu principal de caractères,
- attributs de visualisation :
état latent (4/10)
fin d'état latent (4/11)
double largeur (4/14)
double taille (4/15)
fin de lignage (5/9)
début de lignage (5/10)
fond transparent (5/14)
démasquage (5/15).

Une image vidéographique du système TELETEL ne peut donc être transcodée en une image vidéographique compatible avec les systèmes PRESTEL et TELETEL et identique à l'image de départ que si cette dernière ne comporte aucun des codes indiqués ci-dessus.

Il est évident que si l'image primaire du système TELETEL comporte des caractères du jeu G2, il n'est pas possible de produire une image secondaire essentiellement identique à l'image primaire, puisque cette image secondaire, pour être compatible avec le système PRESTEL, ne doit pas comporter de caractères de ce jeu G2. En revanche, si le code non transcodable de l'image primaire est par exemple l'attribut de visualisation "lignage", la suppression de cet attribut dans l'image secondaire peut ne pas en modifier fondamentalement l'aspect. Il reste dans ce cas possible de produire une image secondaire essentiellemnt identique à l'image primaire.

Enfin, les codes de commande et les attributs de visualisation du langage vidéographique TELETEL qui peuvent être transcodés sont :
- codes de commande : REP (1/2)

SO (0/14)
SI (0/15)
US (1/15)
- attributs de visualisation :
couleur de fond (5/0 à 5/7)
fond normal (5/12)
inversion de fond (5/13).

On peut donc constater que la majorité des codes du langage vidéographique du système TELETEL sont interprétables, ou peuvent être transcodés de manière à être interprétables, par un système PRESTEL.

On va indiquer, pour chacun des codes de commande et de visualisation qui peuvent être transcodés la suite de données inscrites dans le message vidéographique secondaire en remplacement de la donnée du message vidéographique primaire représentant ce code.

## 1. Code SO (0/14)

Le code SO ("shift out") permet le passage en mode semi-graphique ou mosaïque. Ce mode se termine avec le code SI (shift in) de retour au jeu principal G0. Tout code de caractère disposé entre les codes SO et SI désigne des caractères semi-graphiques.

La donnée 0/14 représentant le code SO dans le message vidéographique primaire est remplacée, dans le message vidéographique secondaire, par la suite de données : 0/14, 5/2, 5/0, 4/2, 0/13, 0/9, ..., 0/9.

Cette suite de données produit un effet identique sur les terminaux TELETEL et PRESTEL. Elle commande le passage en mode semi-graphique sur fond noir et précise la couleur du tracé. Dans l'exemple choisi, la couleur de tracé est verte (ceci est indiqué par les deuxième et quatrième données de la suite) ; tout autre couleur peut être sélectionnée. Si on désire une couleur de fond autre que la couleur noire, il suffit de faire suivre cette suite de données de la suite de données correspondant au changement de couleur de fond qui sera décrite ultérieurement.

Pour vérifier que la suite indiquée est interprétée de la même manière par les terminaux TELETEL et PRESTEL, supposons que le curseur de l'écran soit situé dans l'emplacement de caractère de coordonnées (i, j) où i est le numéro de ligne et j le numéro de colonne.

La suite de données 0/14, 5/2, 5/0 et 4/2 correspond pour un terminal TELETEL aux odes successifs : passage en mode mosaïque, couleur de fond verter, couleur de fond noire et couleur de tracé verte. Cette suite comprend un code de commande suivi de trois attributs de visualisation en parallèle qui ne modifient pas la position du curseur, celui-ci reste dans l'emplacement de caractère de coordonnées (i, j).

Cette même suite de données reçue par un terminal PRESTEL comporte l'unique code "passage en mosaïque verte" (5/2), les autres données qui ne correspondent à aucun code étant ignorées. Ce code est un attribut de visualisation en série. Il déplace le curseur d'un emplacement de caractère vers la droite. Le curseur se trouve alors dans l'emplacement de caractère de coordonnées (i+1,j).

La suite des quatre premières données du message vidéographique secondaire produit donc la même fonction sur un terminal TELETEL et sur un terminal PRESTEL, mais ne déplace pas le curseur de la même manière car certains codes correspondent à des attributs parallèles de TELETEL (sans action sur le curseur) et à des attributs série de PRESTEL (déplaçant le curseur). Le repositionnement correct du curseur dans l'emplacement du caractère de coordonnées (i+1,j) est assuré par la suite de données 0/13, 0/9, ..., 0/9. Ces données correspondent à des codes identiques pour les terminaux TELETEL et PRESTEL. Le code 0/13 ("retour chariot") ramène le curseur dans l'emplacement de caractère de coordonnées (0,j). Chaque code 0/9 ("tabulation horizontale") déplace le curseur d'un emplacement de caractère vers la droite. Pour amener le curseur dans l'emplacement de caractère de coordonnées (i+1,j), le message vidéographique secondaire comporte une suite de i+1 codes 0/9.

## 2. Code SI (0/15)

Le code SI ("shift in") permet de repasser du jeu G1 des codes de caractères semi-graphiques au jeu principal GO des codes de caractères alphanumériques. La donnée 0/15 du message vidéographique primaire est transcodée dans le message vidéographique secondaire par la suite de données : 0/15, 4/2, 0/13, 0/9, ..., 0/9.

Cette suite de données commande le passage en mode alphanumérique et précise la couleur du tracé (deuxième donnée de la suite). Dans l'exemple choisi, la couleur de tracé est verte ; tout autre couleur peut être sélectionnée.

Les deux premières données correspondent respectivement, pour un terminal TELETEL, au code de retour au jeu GO et à la couleur de tracé verte. Ces données n'ont pas d'action sur le curseur. Pour un terminal PRESTEL, la donnée 0/15 est ignorée et la donnée 4/2 signifie couleur de tracé verte en mode alphanumérique. Ce code déplace le curseur d'un emplacement de caractère.

La suite de données 0/13, 0/9, ..., 0/9 réalise un repositionnement du curseur analogue à celui du transcodage du code SO.

### 3. REP (1/2)

Dans le message vidéographique primaire, ce code de répétition est suivi d'un argument numérique indiquant le nombre de fois où le code précédant ce code de répétition doit être répété. Ce code de répétition n'existant pas dans le langage vidéographique du système PRESTEL, il est remplacé, dans le message vidéographique secondaire, par la répétition explicite du code qui le précède.

### 4. US (1/15)

Ce code permet un positionnement direct du curseur dans le système TELETEL. Il est suivi de deux arguments indiquant respectivement le numéro de ligne et le numéro de colonne de la nouvelle position du curseur. Ce code n'existe pas dans le langage vidéographique du système PRESTEL. Il est donc remplacé, dans le message vidéographique secondaire, par un positionnement relatif basé sur l'adresse courante, qui est toujours mémorisée, au moyen d'une suite de codes de positionnement du curseur (données 0/8 à 0/13).

### 5. Couleur de fond (5/0 à 5/7)

Pour un terminal TELETEL, la couleur de fond peut être définie directement par les codes 5/0 à 5/7. Cette possibilité n'existe pas pour un terminal PRESTEL qui ne peut modifier la couleur de fond que par le code 5/12 (fond noir) ou par le code 5/13 (nouveau fond) qui définit comme nouvelle couleur de fond la couleur de tracé courante.

On va décrire à titre d'exemple la suite de données du message vidéographique secondaire correspondant à une couleur de tracé jaune sur fond bleu. Au début de cette suite de données, le curseur se trouve dans l'emplacement de caractère de coordonnées (i,j). La suite de données 4/3 (couleur de tracé jaune) et 5/4 (couleur de fond bleu) du message vidéographique primaire est remplacée par la suite de données : 2/0, 5/4, 2/0, 2/0, (repositionnement), 4/4, 5/13, 4/3, 5/12, (repositionnement).

Le premier repositionnement comprend une suite de codes pour ramener le curseur dans l'emplacement de caractère de coordonnées (i,j) et le second repositionnement pour ramener le curseur dans l'emplacement de caractère de coordonnées (i+3,j). On otient ainsi, sur les terminaux TELETEL et PRESTEL, une écriture jaune sur fond bleu précédée d'un espace noir et de deux espaces bleus.

La deuxième donnée de la suite (5/4 dans l'exemple choisi), et les première et troisième données suivant le premier repositionnement (4/4 et 4/3) définissent la couleur de fond et la couleur de tracé sélectionnés. Toute combinaison peut être définie, à l'exception de la couleur de tracé noire qui est impossible dans le système PRESTEL.

La suite de données représentant, dans le message vidéographique secondaire, le code de changement de couleur de fond est remarquable en ce qu'elle contient des données qui correspondent à des codes différents des langages vidéographiques des systèmes TELETEL et PRESTEL.

### 6. Fond normal (/12) et fond inversé (5/13)

Ces codes peuvent être traités comme un changement de couleurs de fond et de tracé.

Pour reproduire une image secondaire essentiellement identique à l'image primaire, il faut également tenir compte du fait que tous les attributs de visualisation sont réinitialisés en début de ligne d'image dans le système PRESTEL- le code 0/13 ("retour chariot") annule les attributs de visualisation- alors que dans le système TELETEL, seuls les attributs de visualisation en série (couleur de fond, masquage, lignage et taille) sont rendus inactifs par un passage à la ligne.

Une solution simple pour résoudre cette difficulté consiste à réinscrire, dans le message vidéographique secondaire la valeur des attributs du visualisation après chaque passage à la ligne et après le code US (1/15) de positionnement direct du curseur.

## TABLEAU I

| b7 | | | | | 0 | 0 | 1 | 1 | 1 | 1 |
|----|---|---|---|---|---|---|---|---|---|---|
| **b6** | | | | | 1 | 1 | 0 | 0 | 1 | 1 |
| **b5** | | | | | 0 | 1 | 0 | 1 | 0 | 1 |
| **b4** | **b3** | **b2** | **b1** | | **2** | **3** | **4** | **5** | **6** | **7** |
| 0 | 0 | 0 | 0 | **0** |  | 0 | @ | P | — | p |
| 0 | 0 | 0 | 1 | **1** | ! | 1 | A | Q | a | q |
| 0 | 0 | 1 | 0 | **2** | ,, | 2 | B | R | b | r |
| 0 | 0 | 1 | 1 | **3** | ▓ | 3 | C | S | c | s |
| 0 | 1 | 0 | 0 | **4** | ▓ | 4 | D | T | d | t |
| 0 | 1 | 0 | 1 | **5** | % | 5 | E | U | e | u |
| 0 | 1 | 1 | 0 | **6** | & | 6 | F | V | f | v |
| 0 | 1 | 1 | 1 | **7** | ' | 7 | G | W | g | w |
| 1 | 0 | 0 | 0 | **8** | [ | 8 | H | X | h | x |
| 1 | 0 | 0 | 1 | **9** | ] | 9 | I | Y | i | y |
| 1 | 0 | 1 | 0 | **10** | ＊ | : | J | Z | j | z |
| 1 | 0 | 1 | 1 | **11** | + | ; | K | [ | k | { |
| 1 | 1 | 0 | 0 | **12** | , | < | L | \ | l | \| |
| 1 | 1 | 0 | 1 | **13** | – | = | M | ] | m | } |
| 1 | 1 | 1 | 0 | **14** | . | > | N | ▓ | n |  |
| 1 | 1 | 1 | 1 | **15** | / | ? | O |  | o |  |

## TABLEAU II

| | | | | b7 | 0 | 0 | 1 | 1 | 1 | 1 |
|---|---|---|---|---|---|---|---|---|---|---|
| | | | | b6 | 1 | 1 | 0 | 0 | 1 | 1 |
| | | | | b5 | 0 | 1 | 0 | 1 | 0 | 1 |
| b4 | b3 | b2 | b1 | | 2 | 3 | 4 | 5 | 6 | 7 |
| 0 | 0 | 0 | 0 | 0 | | | | | | |
| 0 | 0 | 0 | 1 | 1 | | | | | | |
| 0 | 0 | 1 | 0 | 2 | | | | | | |
| 0 | 0 | 1 | 1 | 3 | | | | | | |
| 0 | 1 | 0 | 0 | 4 | | | | | | |
| 0 | 1 | 0 | 1 | 5 | | | | | | |
| 0 | 1 | 1 | 0 | 6 | | | | | | |
| 0 | 1 | 1 | 1 | 7 | | | | | | |
| 1 | 0 | 0 | 0 | 8 | | | | | | |
| 1 | 0 | 0 | 1 | 9 | | | | | | |
| 1 | 0 | 1 | 0 | 10 | | | | | | |
| 1 | 0 | 1 | 1 | 11 | | | | | | |
| 1 | 1 | 0 | 0 | 12 | | | | | | |
| 1 | 1 | 0 | 1 | 13 | | | | | | |
| 1 | 1 | 1 | 0 | 14 | | | | | | |
| 1 | 1 | 1 | 1 | 15 | | | | | | |

## TABLEAU III

| b7 | | | | | | | 0 | 0 | 1 | 1 | 1 | 1 |
|---|---|---|---|---|---|---|---|---|---|---|---|---|
| b6 | | | | | | | 1 | 1 | 0 | 0 | 1 | 1 |
| b5 | | | | | | | 0 | 1 | 0 | 1 | 0 | 1 |
| b4 | b3 | b2 | b1 | | | | 2 | 3 | 4 | 5 | 6 | 7 |
| 0 | 0 | 0 | 0 | | 0 | | | ° | | — | Ω | $\mathcal{K}$ |
| 0 | 0 | 0 | 1 | | 1 | | i | ± | ` | | Æ | æ |
| 0 | 0 | 1 | 0 | | 2 | | ¢ | ² | ´ | | Đ | đ |
| 0 | 0 | 1 | 1 | | 3 | | £ | ³ | ^ | | <u>a</u> | ð |
| 0 | 1 | 0 | 0 | | 4 | | $ | × | ¯ | | Ħ | ħ |
| 0 | 1 | 0 | 1 | | 5 | | ¥ | µ | ¯ | | | I |
| 0 | 1 | 1 | 0 | | 6 | | # | π | ˘ | | IJ | ij |
| 0 | 1 | 1 | 1 | | 7 | | ҕ | · | ˙ | | Ŀ | ŀ |
| 1 | 0 | 0 | 0 | | 8 | | ¤ | ÷ | ¨ | | Ł | t |
| 1 | 0 | 0 | 1 | | 9 | | ' | ' | | | Ø | ø |
| 1 | 0 | 1 | 0 | | 10 | | " | " | ° | | Œ | œ |
| 1 | 0 | 1 | 1 | | 11 | | « | » | ¸ | | <u>o</u> | ß |
| 1 | 1 | 0 | 0 | | 12 | | ← | ¼ | | | Þ̄ | þ̄ |
| 1 | 1 | 0 | 1 | | 13 | | ↑ | ½ | ˝ | | Ŧ | ŧ |
| 1 | 1 | 1 | 0 | | 14 | | → | ¾ | ˛ | | ŋ | ḣ |
| 1 | 1 | 1 | 1 | | 15 | | ↓ | ¿ | ˇ | | 'n | |

## TABLEAU IV

| $b_7$ | | 0 | 0 |
|---|---|---|---|
| $b_6$ | | 0 | 0 |
| $b_5$ | | 0 | 1 |

| $b_4$ | $b_3$ | $b_2$ | $b_1$ | | 0 | 1 |
|---|---|---|---|---|---|---|
| 0 | 0 | 0 | 0 | 0 | NUL | |
| 0 | 0 | 0 | 1 | 1 | | Con |
| 0 | 0 | 1 | 0 | 2 | | Rep |
| 0 | 0 | 1 | 1 | 3 | | |
| 0 | 1 | 0 | 0 | 4 | | Coff |
| 0 | 1 | 0 | 1 | 5 | | |
| 0 | 1 | 1 | 0 | 6 | | |
| 0 | 1 | 1 | 1 | 7 | | |
| 1 | 0 | 0 | 0 | 8 | BS | |
| 1 | 0 | 0 | 1 | 9 | HT | SS2 |
| 1 | 0 | 1 | 0 | 10 | LF | |
| 1 | 0 | 1 | 1 | 11 | VT | ESC |
| 1 | 1 | 0 | 0 | 12 | FF | |
| 1 | 1 | 0 | 1 | 13 | CR | |
| 1 | 1 | 1 | 0 | 14 | SO | RS |
| 1 | 1 | 1 | 1 | 15 | SI | US |

## TABLEAU V

| $b_7$ | 1 | | 1 | |
|---|---|---|---|---|
| $b_6$ | 0 | | 0 | |
| $b_5$ | 0 | | 1 | |
| | | 4 | | 5 |
| $b_4$ $b_3$ $b_2$ $b_1$ | | | | |
| 0 0 0 0 — 0 | tracé noir | | fond noir | |
| 0 0 0 1 — 1 | "   rouge | | "   rouge | |
| 0 0 1 0 — 2 | "   vert | | "   vert | |
| 0 0 1 1 — 3 | "   jaune | | "   jaune | |
| 0 1 0 0 — 4 | "   bleu | | "   bleu | |
| 0 1 0 1 — 5 | "   magenta | | "   magenta | |
| 0 1 1 0 — 6 | "   cyan | | "   cyan | |
| 0 1 1 1 — 7 | "   blanc | | "   blanc | |
| 1 0 0 0 — 8 | clignotement | | masquage | |
| 1 0 0 1 — 9 | fixe | | fin de lignage | |
| 1 0 1 0 — 10 | état latent | | début de lignage | |
| 1 0 1 1 — 11 | fin d'état latent | | | |
| 1 1 0 0 — 12 | taille normale | | fond normal | |
| 1 1 0 1 — 13 | double hauteur | | inversion de fond | |
| 1 1 1 0 — 14 | double largeur | | fond transparent | |
| 1 1 1 1 — 15 | double taille | | démasquage | |

EP 0 209 441 B1

## TABLEAU VI

| b7 b6 b5 → | 0 1 0 | 0 1 1 | 1 0 0 | 1 0 1 | 1 1 0 | 1 1 1 |
|---|---|---|---|---|---|---|
| b4 b3 b2 b1 | **2** | **3** | **4** | **5** | **6** | **7** |
| 0 0 0 0 — 0 | | 0 | @ | P | — | p |
| 0 0 0 1 — 1 | ! | 1 | A | Q | a | q |
| 0 0 1 0 — 2 | " | 2 | B | R | b | r |
| 0 0 1 1 — 3 | £ | 3 | C | S | c | s |
| 0 1 0 0 — 4 | $ | 4 | D | T | d | t |
| 0 1 0 1 — 5 | % | 5 | E | U | e | u |
| 0 1 1 0 — 6 | & | 6 | F | V | f | v |
| 0 1 1 1 — 7 | ' | 7 | G | W | g | w |
| 1 0 0 0 — 8 | [ | 8 | H | X | h | x |
| 1 0 0 1 — 9 | ] | 9 | I | Y | i | y |
| 1 0 1 0 — 10 | * | : | J | Z | j | z |
| 1 0 1 1 — 11 | + | ; | K | — | k | ½ |
| 1 1 0 0 — 12 | , | < | L | / | l | l |
| 1 1 0 1 — 13 | – | = | M | — | m | ¼ |
| 1 1 1 0 — 14 | · | > | N | l | n | – |
| 1 1 1 1 — 15 | / | ? | O | ♯ | o | |

## TABLEAU VII

| $b_4$ | $b_3$ | $b_2$ | $b_1$ | | 0 | 1 |
|---|---|---|---|---|---|---|
| 0 | 0 | 0 | 0 | 0 | NUL | |
| 0 | 0 | 0 | 1 | 1 | | C$_{on}$ |
| 0 | 0 | 1 | 0 | 2 | | |
| 0 | 0 | 1 | 1 | 3 | | |
| 0 | 1 | 0 | 0 | 4 | | C$_{off}$ |
| 0 | 1 | 0 | 1 | 5 | ENQ | |
| 0 | 1 | 1 | 0 | 6 | | |
| 0 | 1 | 1 | 1 | 7 | | |
| 1 | 0 | 0 | 0 | 8 | BS | |
| 1 | 0 | 0 | 1 | 9 | HT | |
| 1 | 0 | 1 | 0 | 10 | LF | |
| 1 | 0 | 1 | 1 | 11 | VT | ESC |
| 1 | 1 | 0 | 0 | 12 | FF | |
| 1 | 1 | 0 | 1 | 13 | CR | |
| 1 | 1 | 1 | 0 | 14 | | RS |
| 1 | 1 | 1 | 1 | 15 | | |

$b_7$: 0 0
$b_6$: 0 0
$b_5$: 0 1

## TABLEAU VIII

| b_7 | | 1 | | 1 |
|---|---|---|---|---|
| b_6 | | 0 | | 0 |
| b_5 | | 0 | | 1 |
| | | 4 | | 5 |
| $b_4$ | $b_3$ | $b_2$ | $b_1$ | | | |
| 0 | 0 | 0 | 0 | 0 | | |
| 0 | 0 | 0 | 1 | 1 | tracé rouge | mosaïque rouge |
| 0 | 0 | 1 | 0 | 2 | "     vert | "     vert |
| 0 | 0 | 1 | 1 | 3 | "     jaune | "     jaune |
| 0 | 1 | 0 | 0 | 4 | "     bleu | "     bleu |
| 0 | 1 | 0 | 1 | 5 | "     magenta | "     magenta |
| 0 | 1 | 1 | 0 | 6 | "     cyan | "     cyan |
| 0 | 1 | 1 | 1 | 7 | "     blanc | "     blanc |
| 1 | 0 | 0 | 0 | 8 | clignotement | affichage invalidé |
| 1 | 0 | 0 | 1 | 9 | fixe | mosaïques contiguës |
| 1 | 0 | 1 | 0 | 10 | | mosaïques disjointes |
| 1 | 0 | 1 | 1 | 11 | | |
| 1 | 1 | 0 | 0 | 12 | taille normale | fond noir |
| 1 | 1 | 0 | 1 | 13 | double hauteur | nouveau fond |
| 1 | 1 | 1 | 0 | 14 | | mosaïque maintenue |
| 1 | 1 | 1 | 1 | 15 | | mosaïque abandonnée |

EP 0 209 441 B1

## Revendications

1. Procédé de transcodage d'un message vidéographique primaire décrivant une image primaire dans un premier langage vidéographique en un message vidéographique secondaire décrivant une image secondaire dans ledit premier langage vidéographique et une image secondaire dans au moins un autre langage vidéographique, lesdites images secondaires étant essentiellement identiques à l'image primaire, lesdits messages vidéographiques étant composés d'une suite de données binaires, chaque donnée binaire étant associée par chaque langage vidéographique un code particulier, ledit procédé de transcodage étant caractérisé en ce que le transcodage de chaque donnée du message vidéographique primaire comprend les opérations suivantes :
- on compare le code du premier langage vidéographique associé à ladite donnée aux codes des autres langages vidéographiques associés à ladite donnée pour déterminer si ledit code est identique auxdits codes ou si ledit code est différent d'au moins un desdits codes,
   A) si ledit code est identique auxdits codes, on inscrit la donnée dans le message vidéographique secondaire,
   B) si ledit code est différent d'au moins un desdits codes, on détermine si la donnée est associée à un code de caractère ou à un code de commande ou de visualisation,
      Ba) si la donnée est associée à un code de caractère, on inscrit une première donnée prédéterminée dans le message vidéographique secondaire,
      Bb) si la donnée est associée à un code de commande ou de visualisation, on détermine si ledit code est transcodable,
         Bbα) si ledit code n'est pas transcodable, on inscrit une deuxième donnée prédéterminée dans le message vidéographique secondaire,
         Bbβ) si ledit code est transcodable, on inscrit dans le message vidéographique secondaire une suite de données telle que les séquences de codes associés à cette suite aient un sens essentiellement identique pour chaque langage vidéographique.
2. Procédé selon la revendication 1, caractérisé en ce que la première donnée prédéterminée est une donnée dont les codes associés de chaque langage vidéographique sont identiques.
3. Procédé selon la revendication 2, caractérisé en ce que la première donnée prédéterminée est la donnée associée au code "espace".
4. Procédé selon la revendication 1, caractérisé en ce que la deuxième donnée prédéterminée est une donnée dont les codes associés de chaque langage vidéographique sont identiques.
5. Procédé selon la revendication 4, caractérisé en ce que la deuxième donnée prédéterminée est la donnée associée au code "NUL".

## Claims

1. Process for the transcoding of a primary videographic message decribing a primary image in a first videographic language into a secondary videographic message describing a secondary image in said first videographic language and a secondary image in at least one other videographic language, said secondary images being essentially identical to the primary image, said videographic messages being formed from a sequence of binary data, each binary data item being associated, by each videographic language with a particular code, said transcoding process being characterized in that the transcoding of each data item of the primary videographic message comprises the following operations: the code of the first videographic language associated with said data item is compared with the codes of the other videographic languages associated with said data item to determine whether said code is identical to said codes or whether said code is different from at least one of said codes,
   A) if said code is identical to said codes, the data item is written into the secondary videographic message,
   B) if said code differs from at least one of said codes, it is established whether the data item is associated with a character code or a control or display code,
      Ba) if the data item is associated with a character code, a first predetermined data item is written in the secondary videographic message,
      Bb) if the data item is associated with a control or display code, it is established whether said code is transcodable,
         Bbα) if said code is not transcodable, a second predetermined data item is written in the secondary videographic message,
         Bbβ) if said code is transcodable, in the secondary videographic message is written a data string in such a way that the sequences of codes associated with said string have an essentially identical meaning for each videographic language.
2. Process according to claim 1, characterized in that the first predetermined data item is a data item, whose associated codes of each videographic language are identical.
3. Process according to claim 2, characterized in that the first predetermined data item is the data item associated with the "space" code.

4. Process according to claim 1, characterized in that the second predetermined data item is a data item, whose associated codes of each videographic language are identical.

5. Process according to claim 4, characterized in that the second predetermined item is the data item associated with the "null" code.

## Patentansprüche

1. Verfahren zur Umcodierung eines Bildschirmprimärtextes, der ein Primärbild in einer ersten Bildschirmsprache beschreibt, in einen Bildschirmsekundärtext, der ein Sekundärbild in der genannten ersten Bildschirmsprache und ein Sekundärbild in wenigstens einer weiteren Bildschirmsprache beschreibt, wobei die genannten Sekundärbilder im wesentlichen mit dem Primärbild identisch sind, die Bildschirmtexte aus einer Folge von Binärdaten zusammengesetzt sind, von denen jede Binärdate durch jede Bildschirmsprache einem spezifischen Code zugeordnet ist, dadurch gekennzeichnet, daß die Umcodierung einer jeden Bildschirmprimärtextdate die folgenden Schritte umfaßt:

Man vergleicht den Code der ersten Bildschirmsprache, der der genannten Daten zugeordnet ist, mit den Codes der anderen Bildschirmsprachen, die der genannten Date zugeordnet sind, um zu ermitteln, ob der genannte Code mit den genannten Codes identisch ist oder ob sich der genannte Code von wenigstens einem der genannten Codes unterscheidet,

A) wenn der genannte Code mit den anderen Codes identisch ist, schreibt man die Date in der Bildschirmsekundärtext ein.

B) wenn der genannte Code von wenigstens einem der anderen Codes verschieden ist, ermittelt man, ob die Date einem Zeichencode oder einem Steuer- oder Anzeigecode zugeordnet ist,

Ba) wenn die Date einem Zeichencode zugeordnet ist, schreibt man eine erste vorbestimmte Date in den Bildschirmsekundärtext ein,

Bb) wenn die Date einem Befehls- oder Anzeigecode zugeordnet ist, ermittelt man, ob der genannte Code umcodierbar ist,

Bbα) wenn der genannte Code nicht umcodierbar ist, schreibt man eine zweite vorbestimmte Date in den Bildschirmsekundärtext ein,

Bbβ) wenn der genannte Code umcodierbar ist, schreibt man in den Bildschirmsekundärtext eine Folge von Daten so ein, daß die Codefolgen, die dieser Folge zugeordnet sind, einen Sinn haben, der für jede Bildschirmsprache im wesentlichen gleich ist.

2. Verfahren nach Anspruch 1, dadurch gekennzeichnet, daß die erste vorbestimmte Date eine Date ist, von der die Codes, die jeder Bildschirmsprache zugeordnet sind, gleich sind.

3. Verfahren nach Anspruch 2, dadurch gekennzeichnet, daß die erste vorbestimmte Date die dem Code "Zwischenraum" zugeordnete Date ist.

4. Verfahren nach Anspruch 1, dadurch gekennzeichnet, daß die zweite vorbestimmte Date eine Date ist, von der die Codes, die jeder Bildschirmsprache zugeordnet sind, gleich sind.

5. Verfahren nach Anspruch 4, dadurch gekennzeichnet, daß die zweite vorbestimmte Date die dem Code "Null" zugeordnete Date ist.

FIG.1

EP 0 209 441 B1

# FIG.2

# FIG.3

# FIG.4